# EUROPEAN PATENT APPLICATION

(11) **EP 4 134 918 A1**
(43) Date of publication of application: **15.02.2023**
(21) Application number: 21785472.8
(22) Date of filing: 01.03.2021
(51) Int. Cl.: G06T 19/00, G05B 19/4069, G06F 11/36, B23Q 15/00, G06F 30/20

(54) **PROGRAM AND DEVICE FOR SIMULATION**

(30) Priority: 10.04.2020 JP 2020071089
(71) Applicant: OMRON Corporation, Kyoto-shi, Kyoto 600-8530 (JP)
(72) Inventor: OHNUKI, Haruna, Kyoto-shi, Kyoto 600-8530 (JP)
(74) Representative: Mewburn Ellis LLP
(86) International application number: PCT/JP2021/007610
(87) International publication number: WO 2021/205776

(57) **Abstract**

A program for causing at least one processor to execute instructions causes the at least one processor to execute determining a group to which a first object (150) belongs and a group to which a second object (140) belongs, executing a simulation including the first object (150) and the second object (140), executing a collision determination between the first object (150) and the second object (140) during execution of the simulation, and changing the group to which the first object (150) belongs when a predetermined condition is satisfied. The collision determination is executed only when the group to which the first object (150) belongs is different from the group to which the second object (140) belongs.

## Description

### TECHNICAL FIELD

The present disclosure relates generally to a simulation program, and more particularly, to a technique of dynamically switching collision detection settings during execution of a simulation.

### BACKGROUND ART

A computer-based simulation has recently been applied to various technical fields. For example, such a simulation is also used for operation confirmation of machines designed by computer aided design (CAD) software, verification work of a line of factory automation (FA) including such machines, and the like.

For simulation, for example, Japanese Patent Laying-Open No. 2016-042378 (PTL 1) discloses a simulation device in which "in accordance with a control program, a command value for moving a virtual machine corresponding to a machine in a virtual space is calculated on the basis of model data of a virtual object that corresponds to an object handled by the virtual machine, motion of the virtual machine in accordance with the calculated command value is calculated, motion of the virtual object to be moved in accordance with the calculated motion of the virtual machine is calculated, a virtual space image that is obtained when the calculated motion of the virtual machine or the calculated motion of the virtual object is virtually scanned is generated, and the command value is calculated further on the basis of the generated virtual space image" (see [ABSTRACT]).

### CITATION LIST

### PATENT LITERATURE

PTL 1: Japanese Patent Laying-Open No. 2016-042378

### SUMMARY OF INVENTION

### TECHNICAL PROBLEM

According to the technique disclosed in PTL 1, it is not possible to dynamically change a setting of collision detection between objects. Therefore, there is a need for a technique for dynamically changing the setting of collision detection between objects.

The present disclosure has been made in view of the above-described circumstances, and it is therefore an object of one aspect to provide a technique for dynamically changing a setting of collision detection between objects.

### SOLUTION TO PROBLEM

According to an example of the present disclosure, provided is a program that causes at least one processor to execute instructions. The instructions include determining a group to which a first object belongs and a group to which a second object belongs, executing a simulation including the first object and the second object, executing a collision determination between the first object and the second object during execution of the simulation, and changing the group to which the first object belongs when a predetermined condition is satisfied. The collision determination is executed only when the group to which the first object belongs is different from the group to which the second object belongs.

According to the above-described disclosure, the program can prevent an unnecessary collision detection process of detecting a collision between objects from being executed and reduce the consumption of computational resources of a device on which the program is run.

In the above-described disclosure, the predetermined condition is defined by an object on which the first object depends in the simulation.

According to the above-described disclosure, the group to which the first object belongs can be changed on the basis of an object with which the first object is in contact.

In the above-described disclosure, the instructions further include changing the object on which the first object depends to the second object based on a change from a state in which the first object is out of contact with the second object to a state in which the first object is in contact with the second object.

According to the above-described disclosure, the program can dynamically switch the group to which the first object belongs on the basis of a contact state between the first object and the second object.

According to the above-described disclosure, the instructions further include monitoring a change of an object with which the first object is in contact, and changing the group to which the first object belongs based on the object with which the first object is in contact each time the change of the object with which the first object is in contact is detected.

According to the above-described disclosure, the program can dynamically switch the group to which the first object belongs based on any object with which the first object is in contact.

In the above-described disclosure, the instructions further include displaying, on a display, an execution status of the simulation. A color of the first object is the same as a color to the second object when the first object and the second object belong to an identical group, and the color of the first object is different from the color of the second object when the first object and the second object belong to different groups.

According to the above-described disclosure, the program can present objects belonging to the same group to a user so as to allow the user to visually recognize the objects with ease.

In the above-described disclosure, the instructions further include changing the color of the first object or a color of an object with which the first object is in contact based on detection of a collision of the first object.

According to the above-described disclosure, the program can present the occurrence of a collision between objects to the user so as to allow the user to visually recognize the occurrence of the collision with ease.

In the above-described disclosure, the instructions further include generating a filter configured to make an object belonging to the group to which the first object belongs not subject to a determination of a collision with the first object, and making, in the collision determination, an object included in the filter not subject to the determination of a collision with the first object.

According to the above-described disclosure, the program can refer to the filter to prevent an unnecessary collision detection process of detecting a collision between objects from being executed.

In the above-described disclosure, the instructions further include setting a dependency relation between the first object and the second object, and setting the first object and the second object to belong to an identical group based on the dependency relation set between the first object and the second object.

According to the above-described disclosure, the program can group objects on the basis of a dependency relation between the objects.

In the above-described disclosure, the instructions further include providing a template for defining the predetermined condition, and receiving, for each template, input to add a process for the first object.

According to the above-described disclosure, the program can provide the user with a means of easily creating a simulation script.

In the above-described disclosure, the process for the first object includes a process of changing an object on which the first object depends.

According to the above-described disclosure, the program can provide the user with a means of inputting a setting for changing the group to which the first obj ect belongs.

In the above-described disclosure, the process for the first object includes a process of switching between on and off of visualization of the first object or the second object.

According to the above-described disclosure, the program can provide the user with a means of inputting a setting for object visualization switching.

In the above-described disclosure, the instructions further include storing a plurality of scripts created based on the template, and receiving input to determine an execution sequence of each of the plurality of scripts.

According to the above-described disclosure, the program can provide the user with a means of determining an execution order of the plurality of scripts.

In the above-described disclosure, the instructions further include switching between a case where motion of one or more objects included in the simulation is performed by simulation and a case where the motion is performed by operating an emulator.

According to the above-described disclosure, the program can incorporate the operation of the emulator into the simulation.

In the above-described disclosure, the instructions further include outputting log information including information on the first object, information on the second object, and a collision time based on detection of a collision between the first object and the second object.

According to the above-described disclosure, the program can provide the user with the log information.

According to another example of the present disclosure, provided is a device including a memory storing a program according to any one of the above, and a processor configured to execute the program.

According to the above-described disclosure, the device can prevent an unnecessary collision detection process of detecting a collision between objects from being executed and reduce the consumption of computational resources of the processor.

### ADVANTAGEOUS EFFECTS OF INVENTION

According to an embodiment, it is possible to dynamically change a setting of collision detection between objects.

The foregoing and other objects, features, aspects and advantages of the present disclosure will become more apparent from the following detailed description of the present disclosure when taken in conjunction with the accompanying drawings.

### BRIEF DESCRIPTION OF DRAWINGS

Fig. 1 is a diagram illustrating an example of an operation outline of a simulation program 100 according to an embodiment.
Fig. 2 is a diagram illustrating an example of a configuration of a line 20 to which simulation program 100 is applicable.
Fig. 3 is a diagram illustrating an example of a configuration of an information processing device 300 on which simulation program 100 is run.
Fig. 4 is a diagram illustrating an example of an outline of an emulation function of simulation program 100.
Fig. 5 is a diagram illustrating an example of a display of a visualizer 530 that is one of the functions of simulation program 100.
Fig. 6 is a diagram illustrating an example of a first user interface (UI) 600 of simulation program 100.
Fig. 7 is a diagram illustrating an example of a second UI 700 of simulation program 100.
Fig. 8 is a diagram illustrating an example of a third UI 800 of simulation program 100.
Fig. 9 is a diagram illustrating an example of a fourth UI 900 of simulation program 100.
Fig. 10 is a diagram illustrating an example of a fifth UI 1000 of simulation program 100.
Fig. 11 is a diagram illustrating an example of a first module configuration of simulation program 100.
Fig. 12 is a diagram illustrating an example of a sequence based on the first module configuration.
Fig. 13 is a diagram illustrating an example of a second module configuration of simulation program 100.
Fig. 14 is a diagram illustrating an example of a first half of a sequence based on the second module configuration.
Fig. 15 is a diagram illustrating an example of a second half of the sequence based on the second module configuration.
Fig. 16 is a diagram illustrating an example of a third module configuration of simulation program 100.
Fig. 17 is a diagram illustrating an example of a first half of a sequence based on the third module configuration.
Fig. 18 is a diagram illustrating an example of a second half of the sequence based on the third module configuration.
Fig. 19 is a diagram illustrating an example of a fourth module configuration of simulation program 100.
Fig. 20 is a diagram illustrating an example of a first half of a sequence based on the fourth module configuration.
Fig. 21 is a diagram illustrating an example of a second half of the sequence based on the fourth module configuration.
Fig. 22 is an example of a flowchart of simulation program 100.

### DESCRIPTION OF EMBODIMENTS

With reference to the drawings, an embodiment of the technical idea according to the present disclosure will be described below. In the following description, the same components are denoted by the same reference numerals. Names and functions of such components are also the same. Therefore, no redundant detailed description will be given of such components.

### <A. Application example>

### (A-1. Object of simulation)

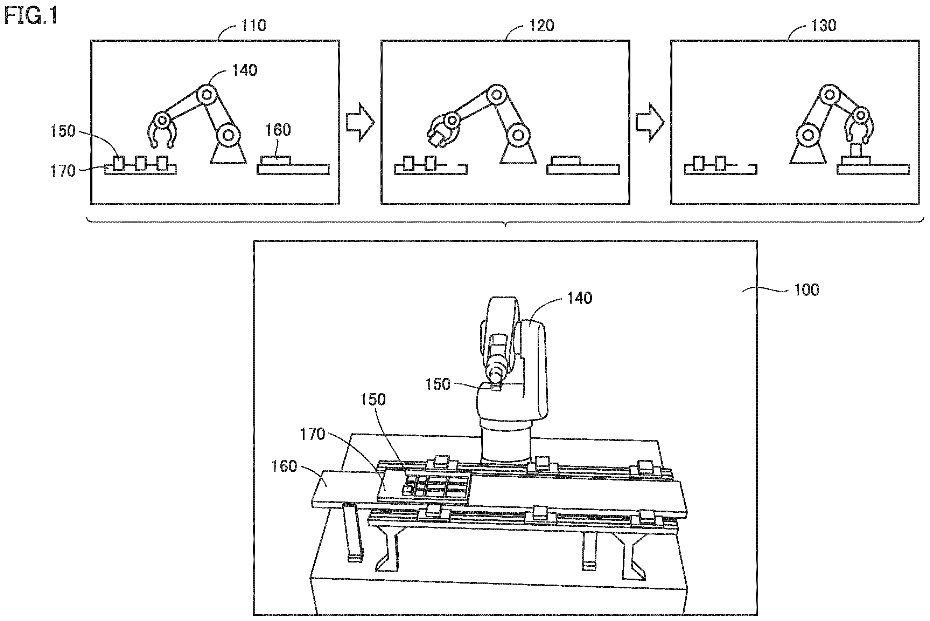

Fig. 1 is a diagram illustrating an example of an operation outline of a simulation program 100 according to the present embodiment. With reference to Fig. 1, an application example of simulation program 100 will be described. Simulation program 100 provides a simulation function of simulating a production line, an inspection line, or the like (may be collectively referred to as "line") including a robot, a machine, or the like installed in a factory or the like.

The line includes a plurality of objects such as a robot arm, a workpiece, a workbench, and a tray. Here, the "workpiece" refers to an object subject to work such as assembling work or inspection work. Simulation program 100 is capable of determining whether such objects come into contact with each other (whether the objects collide with each other) when the production line is put into operation. Simulation program 100 may be run on an information processing device such as a personal computer (PC), a workstation, a server device, or a cloud environment. In the following description, it is assumed that all operations executed by simulation program 100 are executed by the information processing device on which simulation program 100 is installed.

In the example illustrated in Fig. 1, simulation program 100 executes a simulation of a line. The line includes a robot arm 140 and a base 160. A tray 170 is further placed on base 160. Robot arm 140 carries a workpiece 150 on tray 170 to a predetermined position on base 160. Note that the configuration illustrated in Fig. 1 is an example, and the configuration of the line is not limited to such an example. In one aspect, the line may include any number of robot arms, other machines, sensors, or the like. In another aspect, the line may be designed such that a robot and a human conduct work in a cooperative manner.

### (A-2. Switching of object subject to collision determination for each scene)

Simulation program 100 provides the simulation function using mainly a three-dimensional (3D) object. Such a simulation using a 3D object requires large amounts of computational resources and memory. If the information processing device on which simulation program 100 is installed executes collision detection of all objects included in the simulation, computational complexity will significantly increase.

Therefore, simulation program 100 efficiently uses the computational resources of the information processing device by executing only a collision determination on an important specific object. Furthermore, simulation program 100 provides a switching function of switching an object subject to a collision determination for each scene to be described later.

Simulation program 100 divides an operation state of the line into specific scenes. Then, simulation program 100 executes a collision determination process only on an object for which a collision determination is required in each scene. The "scene" herein may be defined on the basis of whether specific objects are in contact with each other. For example, scenes 110, 120, 130 illustrated in Fig. 1 are defined on the basis of which object workpiece 150 is in contact with.

Scene 110 is a scene where robot arm 140 is to hold workpiece 150 placed on tray 170. In scene 110, it is supposed that workpiece 150 is in contact with tray 170. It is further supposed that workpiece 150 is not contact with either robot arm 140 or base 160.

In scene 110, simulation program 100 does not execute a contact determination between workpiece 150 and tray 170. This is because it is a matter of course that workpiece 150 and tray 170 are in contact with each other, and the contact should not be interpreted as an error.

On the other hand, simulation program 100 executes a contact determination between workpiece 150, and robot arm 140 and base 160. This is because such objects should not be in contact with each other. For example, when workpiece 150 and base 160 are in contact with each other, there is a possibility that workpiece 150 or tray 170 is erroneously disposed. Further, when robot arm 140 comes into contact with workpiece 150 at an angle or in an orientation that is not originally intended, there is a high possibility that a control program of robot arm 140 has an error. As described above, simulation program 100 may detect only a collision between objects that becomes a problem in scene 110.

Scene 120 is a scene that is subsequent to scene 110 and where robot arm 140 holds workpiece 150 and lifts workpiece 150 from tray 170. In scene 120, it is supposed that workpiece 150 held by robot arm 140 is in contact with robot arm 140. It is further supposed that workpiece 150 held by robot arm 140 is not in contact with either base 160 or tray 170.

In scene 120, simulation program 100 does not execute a collision determination between workpiece 150 held by robot arm 140 and robot arm 140, because it is a matter of course that workpiece 150 held by robot arm 140 and robot arm 140 are in contact with each other, and the contact should not be interpreted as an error.

On the other hand, simulation program 100 executes a contact determination between workpiece 150 held by robot arm 140, and base 160 and tray 170. Simulation program 100 also executes a collision determination between workpiece 150 held by robot arm 140 and another workpiece 150 placed on base 160. This is because such objects should not be in contact with each other. For example, when workpiece 150 held by robot arm 140 and tray 170 are in contact with each other, there is a possibility that robot arm 140 abnormally lifts workpiece 150 and is dragging workpiece 150 on tray 170. Further, a case where workpiece 150 held by robot arm 140 comes into contact with another workpiece 150 placed on tray 170 corresponds to a case where robot arm 140 brings workpieces 150 into collision with each other. When such a collision is detected, there is a high possibility that the control program of robot arm 140 has an error.

Scene 130 is a scene that is subsequent to scene 120 and where robot arm 140 places workpiece 150 at a predetermined position on base 160. In scene 130, it is supposed that workpiece 150 placed on base 160 is in contact with base 160. It is further supposed that workpiece 150 placed on base 160 is not in contact with either robot arm 140 or tray 170.

In scene 130, simulation program 100 does not execute a contact determination between workpiece 150 placed on base 160 and base 160. This is because it is a matter of course that workpiece 150 placed on base 160 and base 160 are in contact with each other, and the contact should not be interpreted as an error.

On the other hand, simulation program 100 executes a contact determination between workpiece 150 placed on base 160, and robot arm 140 and tray 170. This is because such objects should not be in contact with each other. For example, when workpiece 150 placed on base 160 and tray 170 are in contact with each other, there is a possibility that workpiece 150 is abnormally placed on base 160. When workpiece 150 placed on base 160 and robot arm 140 are in contact with each other, there is a high possibility that the control program of robot arm 140 has an error.

### (A-3. Grouping of objects)

As described above, simulation program 100 groups objects and manages the objects thus grouped in order to switch objects subject to collision detection for each scene.

Simulation program 100 groups objects supposed to be in contact with each other in a certain scene. For example, in scene 110, workpiece 150 and tray 170 are supposed to be in contact with each other. Therefore, simulation program 100 manages workpiece 150 and tray 170 as objects belonging to the same group. On the other hand, workpiece 150 is not supposed to be in contact with either robot arm 140 or base 160. Therefore, simulation program 100 manages workpiece 150 as an object belonging to a group different from a group to which robot arm 140 and base 160 belong. In the example of scene 110, simulation program 100 may group the objects into groups such as a group A (workpiece 150, tray 170), a group B (robot arm 140), and a group C (base 160).

Simulation program 100 does not execute a collision determination between objects belonging to the same group but executes a collision determination between objects belonging to different groups. For example, simulation program 100 does not execute a collision determination between workpiece 150 and tray 170 belonging to the same group in scene 110. On the other hand, simulation program 100 executes a collision determination between workpiece 150, and robot arm 140 and base 160 belonging to different groups in scene 110.

Simulation program 100 provides the user with an input function of defining a group to which each object belongs. Note that simulation program 100 can classify even objects that are in contact with each other into different groups on the basis of input from the user or the like. For example, simulation program 100 may classify base 160 and tray 170 placed on base 160 into different groups.

Simulation program 100 updates the grouping each time a scene is switched (each time a contact relation between specific objects is changed). For example, at the time of switching from scene 110 to scene 120 (when workpiece 150 is held and lifted by robot arm 140), simulation program 100 transfers workpiece 150 from group A to group B to which robot arm 140 belongs. This process prevents a collision determination between workpiece 150 and robot arm 140 from being executed in scene 120.

Furthermore, simulation program 100 defines a dependency relation (parent-child relation) between objects belonging to the same group. In practice, for example, robot arm 140 may include a plurality of objects, such as a robot body, and a robot tool (a tool at a tip of the robot arm). In this case, the robot body is a parent and the robot tool is a child. As another example, the parent of workpiece 150 is tray 170 in scene 110. Simulation program 100 groups a plurality of objects on the basis of a dependency relation defined between such objects. Simulation program 100 defines, for the user, an input function of defining a dependency relation between objects for each scene. Simulation program 100 may update the grouping on the basis of the dependency relation between objects for each scene.

As described above, simulation program 100 groups objects and manages the objects thus grouped, so as to prevent a collision detection process of detecting a collision between objects belonging to the same group from being executed. This allows simulation program 100 to reduce computational resources necessary for simulation.

Furthermore, simulation program 100 executes a process of updating the grouping each time a scene is switched. This allows simulation program 100 to prevent an unnecessary collision detection process of detecting a collision between objects for each scene from being executed.

### <B. Hardware configuration>

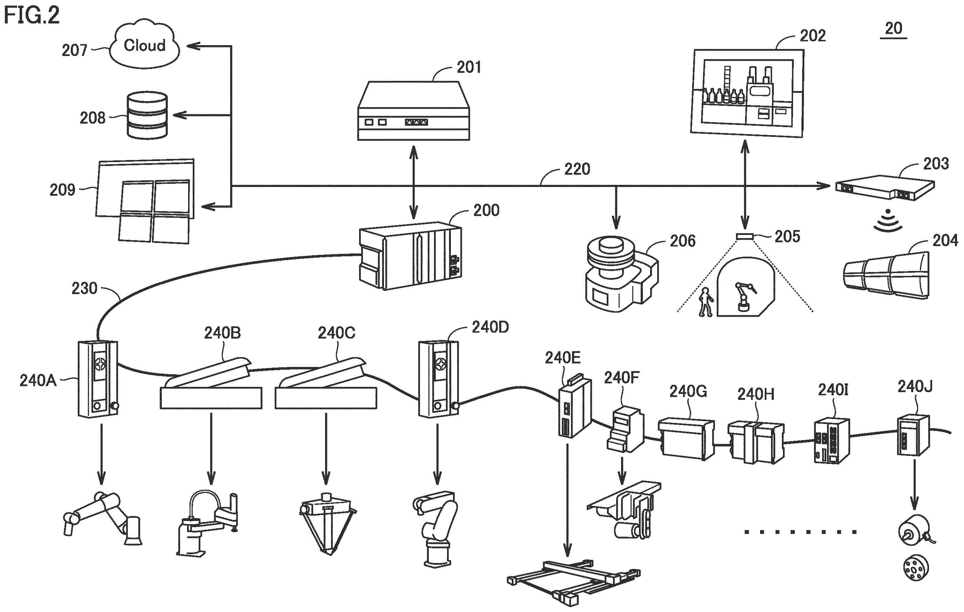

Fig. 2 is a diagram illustrating an example of a configuration of a line 20 to which simulation program 100 is applicable. Line 20 includes an upper transmission path 220 and a lower transmission path 230. An integrated controller 200, an industrial process control (IPC) device 201, a control panel 202, a management device 203, a transfer robot 204, a sensor 205, a light detection and ranging (LiDAR) 206, a cloud environment 207, a database 208, and a simulator 209 are connected to upper transmission path 220.

Integrated controller 200 and field devices 240A to 240J (may be collectively referred to "field device 240") are connected to lower transmission path 230.

Integrated controller 200 controls various actuators such as various sensors, robots, and motors connected to line 20. In other words, integrated controller 200 is a device that functions as both a programmable logic controller (PLC) and a robot controller. In one aspect, line 20 may include a separate PLC and a separate robot controller instead of integrated controller 200.

IPC device 201 is responsible for production management and process management of the entire system in factory automation (FA) or the like. Control panel 202 is used by a factory staff to inspect or operate line 20.

Management device 203 manages and controls, for example, transfer robot 204 and the like. Transfer robot 204 transfers a workpiece or a tray within the factory. Sensor 205 may be used as a safety mechanism. For example, sensor 205 may be used to detect whether a person is present in the vicinity of a robot, a machine tool, or the like. LiDAR 206 is a device that detects a peripheral obstacle using an optical sensor. LiDAR 206 may be used with being mounted on, for example, transfer robot 204 or the like.

Cloud environment 207 is an information processing environment including a plurality of servers inside or outside the factory. Database 208 stores log data and the like transmitted from integrated controller 200, IPC device 201, or the like. Simulator 209 is an information processing device on which simulation program 100 is run. Simulator 209 may execute a simulation that includes some or all the components of line 20. An administrator can actually operate line 20 after confirming that there is no problem in the design of line 20 using simulator 209.

In one aspect, all or some of cloud environment 207, database 208, and simulator 209 may be provided outside the premises of the factory. In this case, all or some of cloud environment 207, database 208, and simulator 209 may be connected to upper transmission path 220 via an external network, a gateway device, or the like (not illustrated).

Field device 240 is a controller such as a robot arm, a scalar device, a linear motion mechanism, or a motor. In one aspect, field device 240 may be built in a robot arm or the like, or may be provided outside the robot arm or the like. In line 20, the plurality of field devices 240 may conduct work in a cooperative manner to, for example, manufacture or inspect products.

Simulation program 100 may execute, for example, collision detection between field device 240 constituting line 20 and a workpiece, collision detection of transfer robot 204, and the like in simulation. Simulation program 100 may be integrated with a development environment of a program of field device 240. In this case, simulator 209 may install a program on field device 240 after completing the simulation of the program.

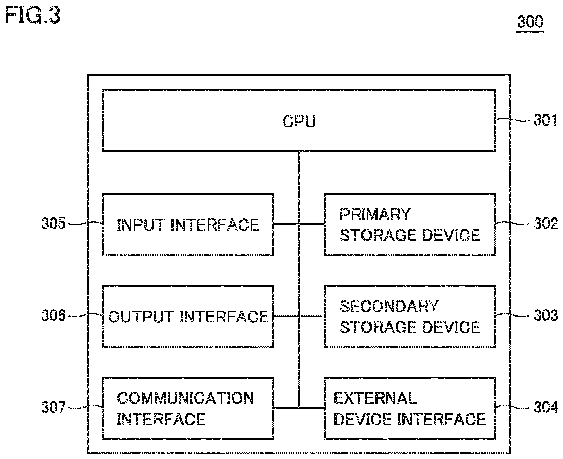

Fig. 3 is a diagram illustrating an example of a configuration of an information processing device 300 on which simulation program 100 is run. Information processing device 300 includes a central processing unit (CPU) 301, a primary storage device 302, a secondary storage device 303, an external device interface 304, an input interface 305, an output interface 306, and a communication interface 307.

CPU 301 may run a program for implementing various functions of information processing device 300. CPU 301 includes, for example, at least one integrated circuit. The integrated circuit may include, for example, at least one CPU, at least one field-programmable gate array (FPGA), or a combination of the CPU and the FPGA. CPU 301 may cause simulation program 100 loaded from secondary storage device 303 into primary storage device 302 to execute the processes described with reference to Fig. 1.

Primary storage device 302 stores the program to be run by CPU 301 and data to be referred to by CPU 301. In one aspect, primary storage device 302 may be implemented by a dynamic random access memory (DRAM), a static random access memory (SRAM), or the like.

Secondary storage device 303 is a non-volatile memory, and may store the program to be run by CPU 301 and data to be referred to by CPU 301. In this case, CPU 301 runs the program loaded from secondary storage device 303 into primary storage device 302 and refers to the data loaded from secondary storage device 303 into primary storage device 302. In one aspect, secondary storage device 303 may be implemented by a hard disk drive (HDD), a solid state drive (SSD), an erasable programmable read only memory (EPROM), an electrically erasable programmable read only memory (EEPROM), a flash memory, or the like.

External device interface 304 may be connected to any external device such as a printer, a scanner, and an external HDD. In one aspect, external device interface 304 may be implemented by a universal serial bus (USB) terminal or the like.

Input interface 305 may be connected to any input device such as a keyboard, a mouse, a touchpad, or a gamepad. In one aspect, input interface 305 may be implemented by a USB terminal, a PS/2 terminal, a Bluetooth (registered trademark) module, or the like.

Output interface 306 may be connected to any output device, such as a cathoderay tube display, a liquid crystal display, or an organic electro-luminescence (EL) display. In one aspect, output interface 306 may be implemented by a USB terminal, a D-sub terminal, a digital visual interface (DVI) terminal, a high-definition multimedia interface (HDMI) (registered trademark) terminal, or the like.

Communication interface 307 is connected to a wired or radio network device. In one aspect, communication interface 307 may be implemented by a wired local area network (LAN) port, a Wi-Fi (registered trademark) module, or the like. In another aspect, communication interface 307 may transmit and receive data using Transmission Control Protocol/Internet Protocol (TCP/IP), User Datagram Protocol (UDP), or another communication protocol.

### <C. Details of simulation program>

### (C-1. Emulation function)

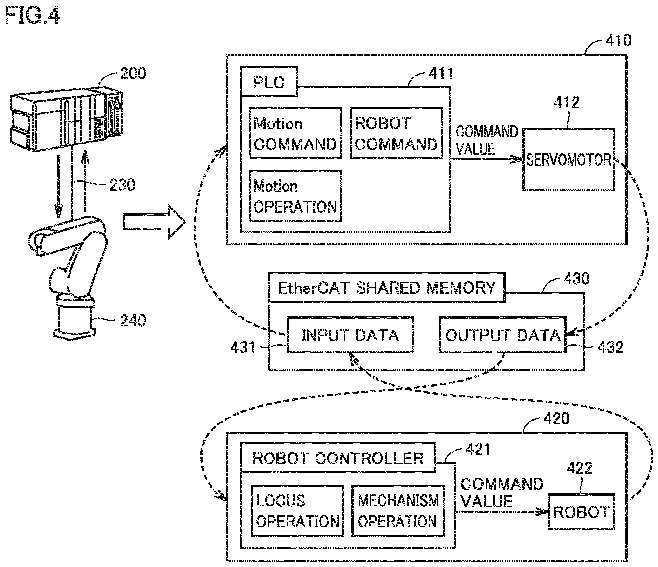

Fig. 4 is a diagram illustrating an example of an outline of an emulation function of simulation program 100. Simulation program 100 provides a function of emulating some or all objects in simulation.

As an example, simulation program 100 generates a virtual PLC 410 and a virtual robot 420. Virtual PLC 410 and virtual robot 420 are each capable of running a real machine program. Therefore, the user can cause virtual PLC 410 and virtual robot 420 to run a created PLC program and robot program, respectively, to verify the operation of each program without preparing a real machine.

Further, simulation program 100 provides an EtherCat shared memory 430 that is an area for passing data to be exchanged between virtual PLC 410 and virtual robot 420. Simulation program 100 allocates a part of primary storage device 302 to EtherCat shared memory 430. Virtual PLC 410 and virtual robot 420 each operate as a virtual independent device. Therefore, input data 431 and output data 432 are passed between the devices via EtherCat shared memory 430.

As an example, virtual PLC 410 includes a PLC body 411 and a servomotor 412 or another actuator controlled by PLC body 411. Further, as an example, virtual robot 420 includes a robot controller 421 corresponding to a control device of a robot body 422 and robot body 422.

### (C-2. User interface)

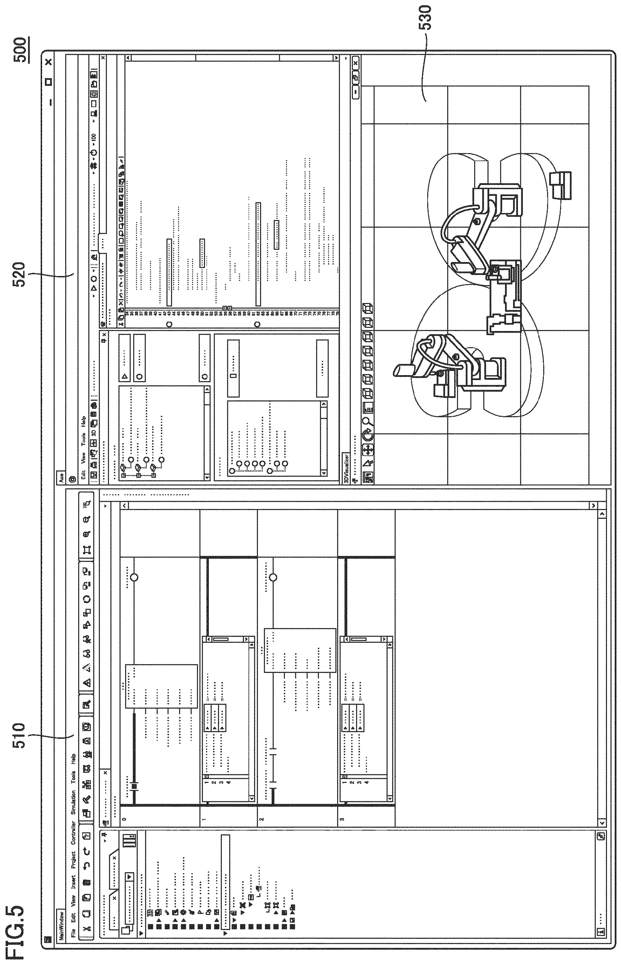

With reference to Figs. 5 to 10, examples of user interfaces provided by simulation program 100 will be described next. Such user interfaces may be provided as part of an integrated development environment (IDE) of integrated controller 200.

Fig. 5 is a diagram illustrating an example of a display of a visualizer 530 that is one of the functions of simulation program 100. In the example illustrated in Fig. 5, simulation program 100 is provided as part of an IDE 500 of integrated controller 200.

IDE 500 includes ladder software 510 and robot program software 520. Ladder software 510 is used in programming of a PLC function of integrated controller 200. A program created by ladder software 510 is installed on integrated controller 200 and run by integrated controller 200 or virtual PLC 410. Robot program software 520 is used in programming of a robot controller function of integrated controller 200. A program created by robot program software 520 is installed on integrated controller 200 and run by integrated controller 200 or virtual robot 420.

IDE 500 further provides a function of visualizer 530. IDE 500 runs simulation program 100 in response to input from the user. Visualizer 530 visualizes a simulation state of each object (a robot arm, a workpiece, and the like) constituting line 20 and displays the simulation state thus visualized on the display.

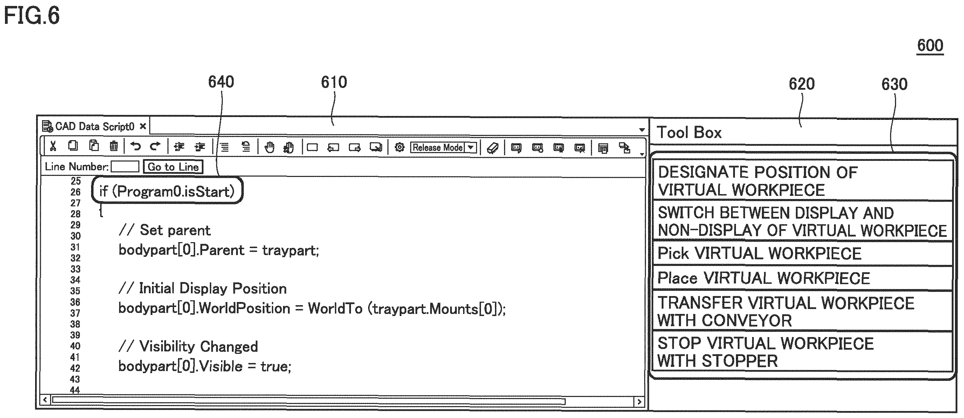

Fig. 6 is a diagram illustrating an example of a first UI 600 of simulation program 100. First UI 600 receives input to define motion in each scene in simulation and generates a script for each scene.

First UI 600 includes an editor 610, a tool box 620, and a template 630. Editor 610 receives input of description of a source code of simulation program 100 from the user.

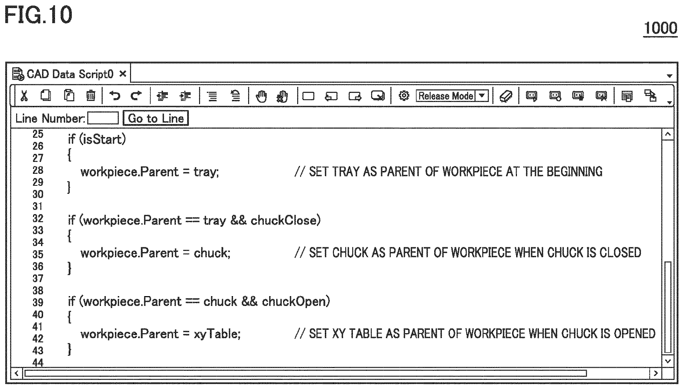

The tool box 620 provides template 630 for the source code of simulation program 100. Template 630 is a template for a source code of a scene that is typically used in simulation. The user can easily create a script defining simulation details of each scene by selecting template 630 and adding a code to template 630 thus selected. In one aspect, template 630 may be used in generation of a script illustrated in Fig. 10 to be described later.

When template 630 is displayed in editor 610, a condition 640 indicating a scene of template 630 is displayed as an example. The user can define simulation details of a specific scene by adding, to template 630, a code of a process when simulation satisfies condition 640. As an example, the user can additionally write settings such as designation of a dependency relation between objects (an object on which a certain object depends), on/off of display of an object, and an initial position of an object in template 630. In one aspect, editor 610 may be displayed in not only a text form but also a flow form, a block form, or any other input form. The user may create, using first UI 600, a script defining simulation details of each of scenes 110, 120, 130 illustrated in Fig. 1, for example.

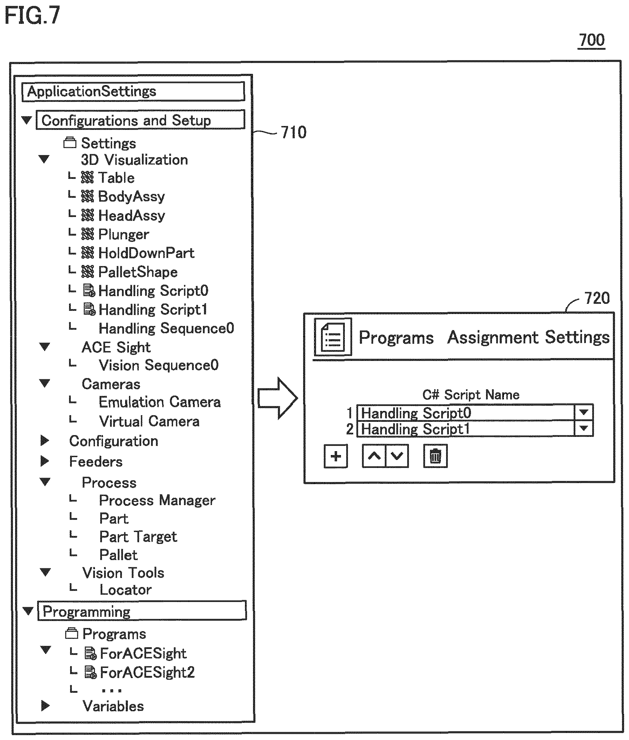

Fig. 7 is a diagram illustrating an example of a second UI 700 of simulation program 100. Second UI 700 receives input to determine an execution order of scenes for which process details have been defined.

A script list 710 is a list including scripts created by means of first UI 600 or the like. The user may select a script from script list 710 and add the selected script to a script execution setting 720.

The user may define, using first UI 600 and second UI 700 described above, process details for each scene in simulation as a script and further easily define the execution order of such scripts (scenes).

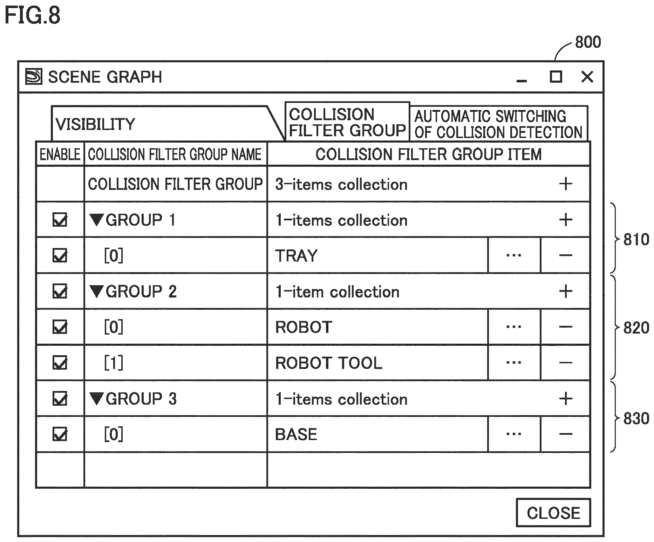

Fig. 8 is a diagram illustrating an example of a third UI 800 of simulation program 100. Third UI 800 receives an operation of setting grouping of objects for each scene. The user may make a group setting for each scene using third UI 800.

In the example illustrated in Fig. 8, groups 810, 820, 830 are set for a certain scene (A). Group 810 includes tray 170. Group 820 includes a robot (the body of robot arm 140) and a robot tool (the tool at the tip of robot arm 140). Group 830 includes base 160.

Simulation program 100 uses information on the groups set for each object by the user using third UI 800 as a "collision filter group" for creating a collision filter. That is, when executing collision detection in scene (A), simulation program 100 refers to groups 810, 820, 830 and does not execute collision detection between objects belonging to the same group (objects for which the possibility of a collision need not be taken into consideration). For example, simulation program 100 does not execute collision detection between the robot and the robot tool belonging to group 820 in scene (A).

As described above, simulation program 100 refers to the group setting to prevent the execution of collision detection between objects for which the possibility of a collision need not be taken into consideration. This allows simulation program 100 to reduce the consumption of computational resources of information processing device 300 and execute a simulation at a higher throughput.

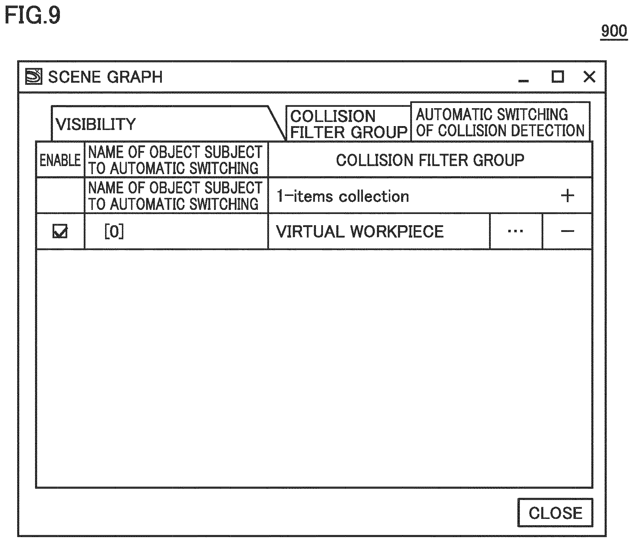

Fig. 9 is a diagram illustrating an example of a fourth UI 900 of simulation program 100. Fourth UI 900 receives, from the user, an operation of selecting an object that is subject to automatic switching of object collision detection for each scene.

In the example illustrated in Fig. 9, a virtual workpiece (workpiece 150) is selected as an object subject to automatic switching of collision detection. A group to which the object selected as an object subject to automatic switching of collision detection belongs is switched each time a scene is switched (for example, each time a collision with another object occurs). The virtual workpiece here refers to a virtual workpiece in simulation. When executing a simulation of the line, the user may create a simulation setting with emphasis on the motion of a workpiece.

Scene switching will be described below with reference to scenes 110 to 130 illustrated in Fig. 1, the groups illustrated in Fig. 8, and the setting illustrated in Fig. 9. First, in scene 110, workpiece 150 is placed on tray 170. In this case, workpiece 150 belongs to group 810 as the child of tray 170.

Next, in scene 120, robot arm 140 (robot tool) holds workpiece 150 and lifts workpiece 150 from tray 170. In this case, workpiece 150 belongs to group 820 as the child of the robot tool.

Finally, in scene 130, robot arm 140 places workpiece 150 on base 160, and robot arm 140 releases workpiece 150. In this case, workpiece 150 belongs to group 830 as the child of base 160.

As described above, an object selected as an object subject to automatic switching of collision detection becomes the child of an object with which contact is dynamically made in the scene set in Figs. 6 and 7, and belongs to the same group as the object with which contact is made.

Fig. 10 is a diagram illustrating an example of a fifth UI 1000 of simulation program 100. Fifth UI 1000 receives input of a scene switching condition and a process to be executed in each scene.

In the example illustrated in Fig. 10, a start time (isStart) is set as a condition of a first scene. Further, as a process to be executed in the first scene, a process (workpiece.Parent = Tray) of setting tray 170 as the parent of workpiece 150 is defined.

Next, a condition of a second scene where the parent of workpiece 150 is tray 170 and a chuck of the robot tool normally holds workpiece 150 (workpiece.Parent == Tray && chuckClose) is set. Further, as a process to be executed in the second scene, a process (workpiece.Parent = Chuck) of setting the robot tool (chuck) as the parent of the workpiece is defined.

Next, a condition of a third scene where the parent of workpiece 150 is the robot tool (chuck) and the chuck of the robot tool has released workpiece 150 (workpiece.Parent == Chuck & & chuckOpen) is set. Further, as a process to be executed in the third scene, a process (workpiece.Parent = xyTable) of setting base 160 (xyTable) as the parent of the workpiece is defined.

Simulation program 100 determines whether the condition indicating each scene is satisfied in simulation. Then, when determining that the condition is satisfied, simulation program 100 determines that the scene defined by the condition is reached. Then, simulation program 100 executes a process to be executed when the condition is satisfied. For example, as a typical process, a process of changing a dependency relation between objects (process of changing a parent object) may be set in each scene.

Simulation program 100 may execute a process of changing a group to which an object belongs on the basis of the group setting set on third UI 800 and the script created on fifth UI 1000. Simulation program 100 may temporarily receive input of the setting of the groups to which all objects belong through third UI 800. Next, simulation program 100 may receive input of a scene switching condition and a process of changing a dependency relation between objects in each scene through fifth UI 1000.

In simulation, when object A becomes the child of object B, simulation program 100 transfers object A to a group to which object B that is the parent of object A belongs. That is, a group set on third UI 800 is an initial group of each object, and each object transfers between groups on the basis of the process of changing a dependency relation for each scene defined on fifth UI 1000.

In one aspect, simulation program 100 may receive input of an initial dependency relation of each object through fifth UI 1000. Further, in another aspect, simulation program 100 may separately provide the user with a UI for setting a dependency relation of each object and an offset between a parent object and a child obj ect.

The user may input, to simulation program 100 using fourth UI 900 and fifth UI 1000 as described above, a setting for dynamically switching an object subject to detection of a collision with a specific object.

In one aspect, simulation program 100 may further provide a UI for setting whether to visualize each object for each scene. The user may input, to simulation program 100 using the UI, a setting for displaying only an object that need to be visually presented to the user on the display.

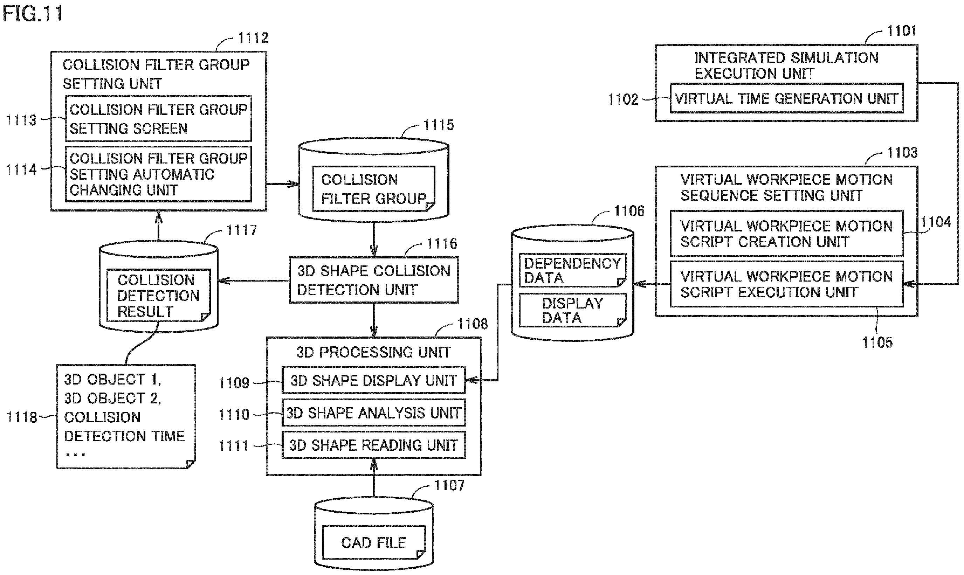

With reference to Figs. 11 to 21, a module configuration of simulation program 100 and communication between modules will be described next. Each module is a program component or data constituting simulation program 100. In one aspect, some or all of such modules may be implemented by hardware.

### (C-3. First module configuration)

Fig. 11 is a diagram illustrating an example of a first module configuration of simulation program 100. Simulation program 100 includes an integrated simulation execution unit 1101, a virtual workpiece motion sequence setting unit 1103, a simulation setting 1106, a CAD database 1107, a 3D processing unit 1108, a collision filter group setting unit 1112, a collision filter group database 1115, a 3D shape collision detection unit 1116, and a collision detection result database 1117.

Integrated simulation execution unit 1101 includes a virtual time generation unit 1102. Virtual workpiece motion sequence setting unit 1103 includes a virtual workpiece motion script creation unit 1104 and a virtual workpiece motion script execution unit 1105. 3D processing unit 1108 includes a 3D shape display unit 1109, a 3D shape analysis unit 1110, and a 3D shape reading unit 1111. Collision filter group setting unit 1112 includes a collision filter group setting screen 1113 and a collision filter group setting automatic changing unit 1114.

Integrated simulation execution unit 1101 executes a simulation on the basis of various scripts and manages the entire simulation. Virtual time generation unit 1102 generates a virtual time in simulation.

Virtual workpiece motion sequence setting unit 1103 receives input of setting (script) of a simulation execution procedure from the user. Further, virtual workpiece motion sequence setting unit 1103 interprets the setting of the simulation execution procedure and execute the simulation execution procedure. Virtual workpiece motion script 1140 receives input of a motion script related to the virtual workpiece from the user. In one aspect, the user may create a motion script related to the virtual workpiece using, for example, first UI 600, second UI 700, fifth UI 1000, and the like. Virtual workpiece motion script execution unit 1105 interprets and executes the motion script related to the virtual workpiece created by the user.

Simulation setting 1106 stores a dependency relation between objects in each scene, display data, and the like. In one aspect, simulation setting 1106 may be expressed as a table of a relational database, or may be expressed in any other data format such as JavaScript (registered trademark) Object Notation (JSON). In another aspect, the data stored in simulation setting 1106 may be created using, for example, third UI 800, fourth UI 900, and the like.

3D processing unit 1108 displays a state where the simulation is running on the display. In one aspect, 3D processing unit 1108 provides the function of reading of CAD data and the function of visualizer 530. In another aspect, 3D processing unit 1108 may display a plurality of objects belonging to the same group in the same color (group color). Further, when an object (virtual workpiece or the like) transfers to another group at the time of scene switching, 3D processing unit 1108 may display the object with the color of the object changed to the color of the group to which the object has transferred. 3D shape display unit 1109 displays execution details of the simulation on the display as needed. 3D shape analysis unit 1110 analyzes a shape of a CAD file stored in CAD database 1107. 3D shape reading unit 1111 reads the CAD file stored in CAD database 1107.

Collision filter group setting unit 1112 receives input of a setting of a collision filter group and automatically updates the collision filter group during execution of the simulation. Each collision filter group corresponds to a group to which the objects described with reference to Fig. 8 and the like belong. Such groups are used as a filter for preventing collision detection between objects belonging to the same group from being executed.

Collision filter group setting screen 1113 receives input of a setting of a group of objects. For example, collision filter group setting screen 1113 includes third UI 800. Collision filter group setting automatic changing unit 1114 receives input of a setting of automatic update of the collision filter group. For example, collision filter group setting automatic changing unit 1114 includes fourth UI 900, fifth UI 1000, and the like.

Collision filter group database 1115 stores data of the collision filter group created by collision filter group setting unit 1112. In one aspect, collision filter group database 1115 may be expressed as a table of a relational database, or may be expressed in any other data format such as JSON.

3D shape collision detection unit 1116 detects a collision between objects during execution of the simulation. 3D shape collision detection unit 1116 refers to the data of the collision filter group to prevent collision detection between objects belonging to the same group from being executed. Upon detection of a collision, 3D shape collision detection unit 1116 stores a collision detection result 1118 (log information) including identification information on each object that has come into collision and a collision detection time into collision detection result database 1117. The collision detection time is based on the virtual time generated by virtual time generation unit 1102. In one aspect, collision detection result database 1117 may be expressed as a table of a relational database, or may be expressed in any other data format such as JSON.

Note that the data created on each of first UI 600 to fifth UI 1000 need not be data explicitly used by any module. In one aspect, some or all pieces of data created on each of first UI 600 to fifth UI 1000 may be used by each module separately or in combination as needed.

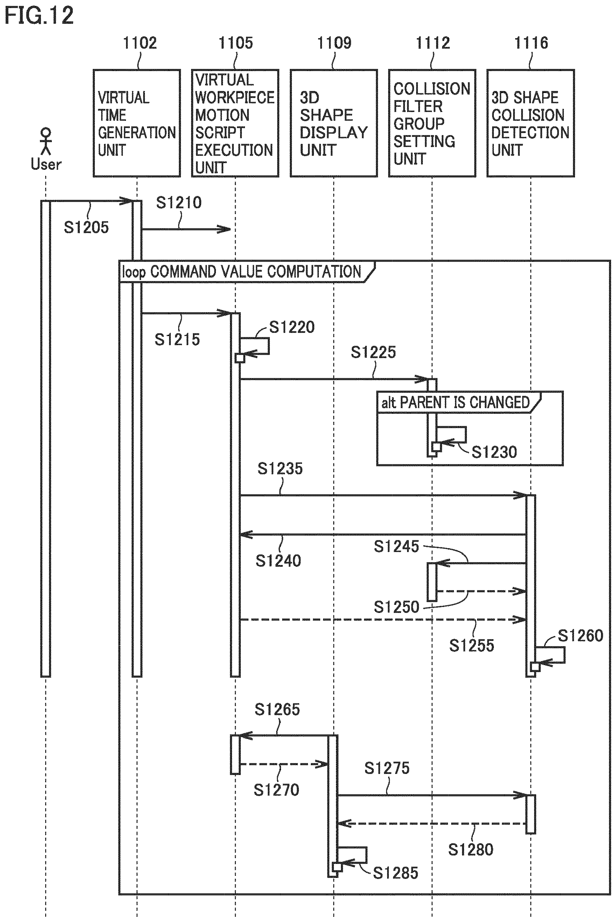

Fig. 12 is a diagram illustrating an example of a sequence based on the first module configuration. The sequence illustrated in Fig. 12 is executed by CPU 301. In one aspect, CPU 301 may implement the sequence based on the first module configuration by executing simulation program 100 loaded from secondary storage device 303 into primary storage device 302.

In step S1205, virtual time generation unit 1102 receives a simulation start command from the user and generates a virtual time. In step S1210, virtual time generation unit 1102 transmits an activation request to virtual workpiece motion script execution unit 1105 together with the virtual time.

In step S1215, virtual time generation unit 1102 transmits an operation command to virtual workpiece motion script execution unit 1105. In one aspect, integrated simulation execution unit 1101 may execute steps S1205 to S1215.

In step S1220, virtual workpiece motion script execution unit 1105 executes a virtual workpiece automatic execution script. The virtual workpiece automatic execution script includes, for example, a script created on fifth UI 1000.

In step S1225, virtual workpiece motion script execution unit 1105 transmits an operation execution notification to collision filter group setting unit 1112. In one aspect, the operation execution notification may include the current position of an object or the like. In another aspect, the operation execution notification may include information indicating the current scene.

In step S1230, collision filter group setting unit 1112 updates a collision filter group upon receipt of the operation execution notification. For example, collision filter group setting unit 1112 changes a group to which a virtual workpiece belongs on the basis of scene switching. More specifically, collision filter group setting unit 1112 changes, on the basis of the script set on fifth UI 1000, a group to which each object belongs each time a scene is switched.

In step S1235, virtual workpiece motion script execution unit 1105 transmits a collision detection request to 3D shape collision detection unit 1116. In step S1240, 3D shape collision detection unit 1116 transmits a request for acquisition of the position of the virtual workpiece to virtual workpiece motion script execution unit 1105 in response to the collision detection request.

In step S1245, 3D shape collision detection unit 1116 transmits a request for acquisition of the collision filter group to collision filter group setting unit 1112. In step S1250, collision filter group setting unit 1112 transmits the collision filter group to 3D shape collision detection unit 1116.

In step S1255, virtual workpiece motion script execution unit 1105 transmits the position of the virtual work to 3D shape collision detection unit 1116. In one aspect, the communications in steps S1240 and S1255 may be executed asynchronously and simultaneously with the communications in steps S1245 and S1250. In step S1260, 3D shape collision detection unit 1116 executes a collision detection process upon receipt of the collision filter group and the position of the virtual workpiece.

In step S1265, 3D shape display unit 1109 transmits a request for acquisition of the position of the virtual workpiece to virtual workpiece motion script execution unit 1105. In step S1270, virtual workpiece motion script execution unit 1105 transmits the position of the virtual work to 3D shape display unit 1109.

In step S1275, 3D shape display unit 1109 transmits a request for acquisition of collision state information to 3D shape collision detection unit 1116. In step S1280, 3D shape collision detection unit 1116 transmits the collision state information to 3D shape display unit 1109. As an example, the collision state information includes identification information on each object, a collision occurrence time, and the like in a case where a collision occurs between objects. In step S1285, 3D shape collision detection unit 1116 updates the display of the screen. For example, the display of visualizer 530 is updated each time step S1285 is executed.

### (C-4. Second module configuration)

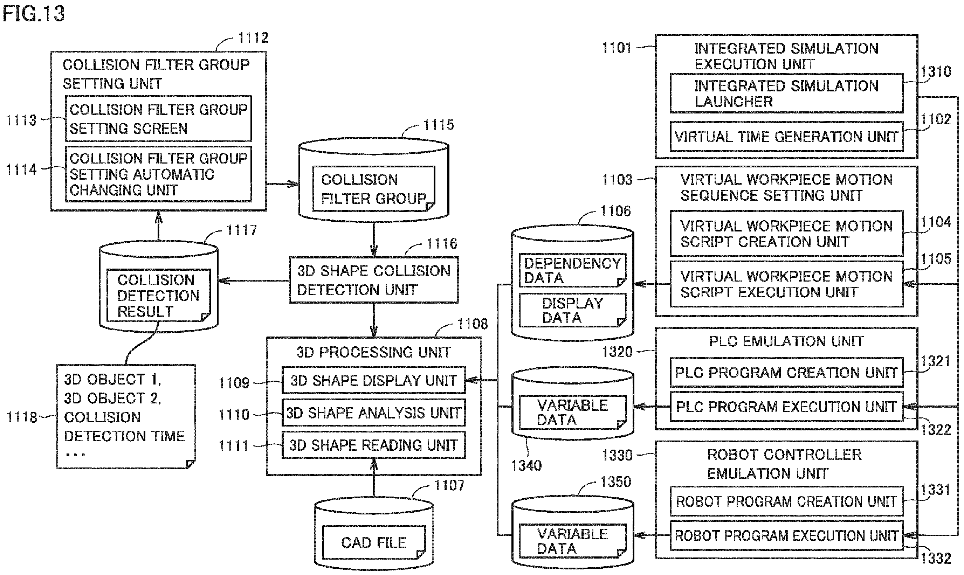

Fig. 13 is a diagram illustrating an example of a second module configuration of simulation program 100. The second module configuration is different from the first module configuration in that the second module configuration is provided with a PLC emulation function and a robot controller emulation function. In one aspect, simulation program 100 may switch between reproduction of each function by means of simulation and reproduction of each function by means of emulation on the basis of the setting made by the user.

The second module configuration includes, in addition to the components included in the first module configuration, a PLC emulation unit 1320, a robot controller emulation unit 1330, a PLC variable database 1340, and a robot controller variable database 1350.

PLC emulation unit 1320 includes a PLC program creation unit 1321 and a PLC program execution unit 1322. Robot controller emulation unit 1330 includes a robot program creation unit 1331 and a robot program execution unit 1332.

PLC emulation unit 1320 emulates the function of the PLC and stores the execution result into PLC variable database 1340. PLC emulation unit 1320 interprets and executes a program that is installable on the PLC of the real machine.

PLC program creation unit 1321 provides a function of creating a program that is installable on the PLC of the real machine. In one aspect, PLC program creation unit 1321 may include ladder software 510. In this case, the user may create a program to be executed by PLC program execution unit 1322 using ladder software 510 or the like.

PLC program execution unit 1322 interprets and executes the program created by PLC program creation unit 1321. In other words, PLC program execution unit 1322 is a virtual PLC. An operation result (output data or the like) of PLC program execution unit 1322 is stored into PLC variable database 1340.

Robot controller emulation unit 1330 emulates the function of the robot controller or the robot body and stores the execution result into robot controller variable database 1350. Robot controller emulation unit 1330 interprets and executes a program that is installable on the robot controller of the real machine.

Robot program creation unit 1331 provides a function of creating a program that is installable on the robot controller of the real machine. In one aspect, robot program creation unit 1331 may include robot program software 520. In this case, the user may create a program to be executed by robot program execution unit 1332 using robot program software 520 or the like.

Robot program execution unit 1332 interprets and executes the program created by robot program creation unit 1331. In other words, robot program execution unit 1332 is a virtual robot controller. An operation result (output data or the like) of robot program execution unit 1332 is stored into robot controller variable database 1350.

PLC variable database 1340 stores a variable of the operation result of PLC program execution unit 1322. This variable may be used by 3D processing unit 1108 and 3D shape collision detection unit 1116 when a PLC emulation result is taken into the simulation.

Robot controller variable database 1350 stores a variable of the operation result of robot program execution unit 1332. This variable may be used by 3D processing unit 1108 and 3D shape collision detection unit 1116 when a robot controller emulation result is taken into the simulation.

In one aspect, PLC variable database 1340 and robot controller variable database 1350 may be expressed as a table of a relational database, or may be expressed in any other data format such as JSON.

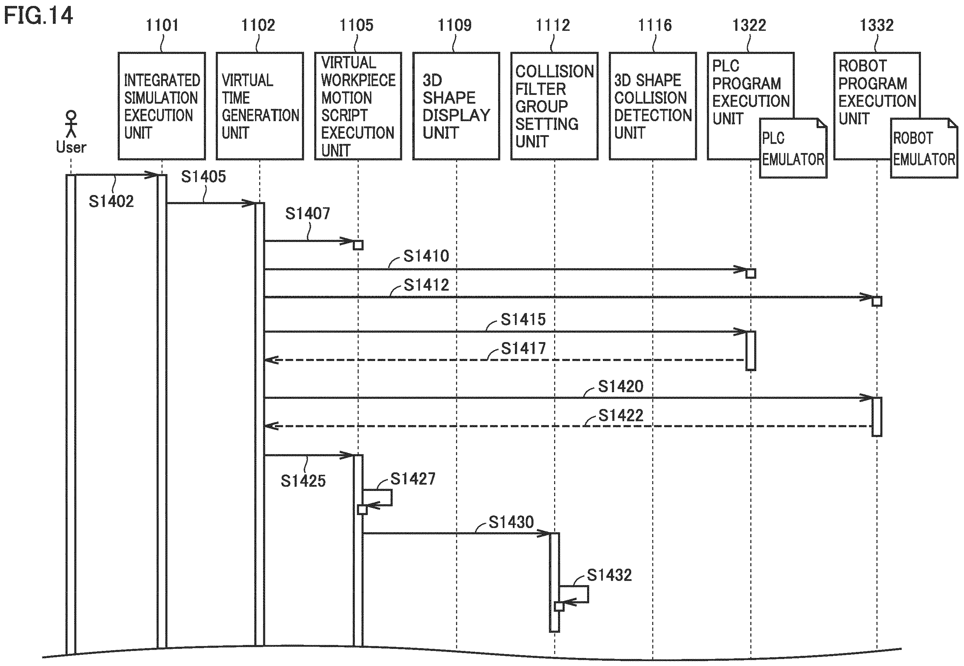

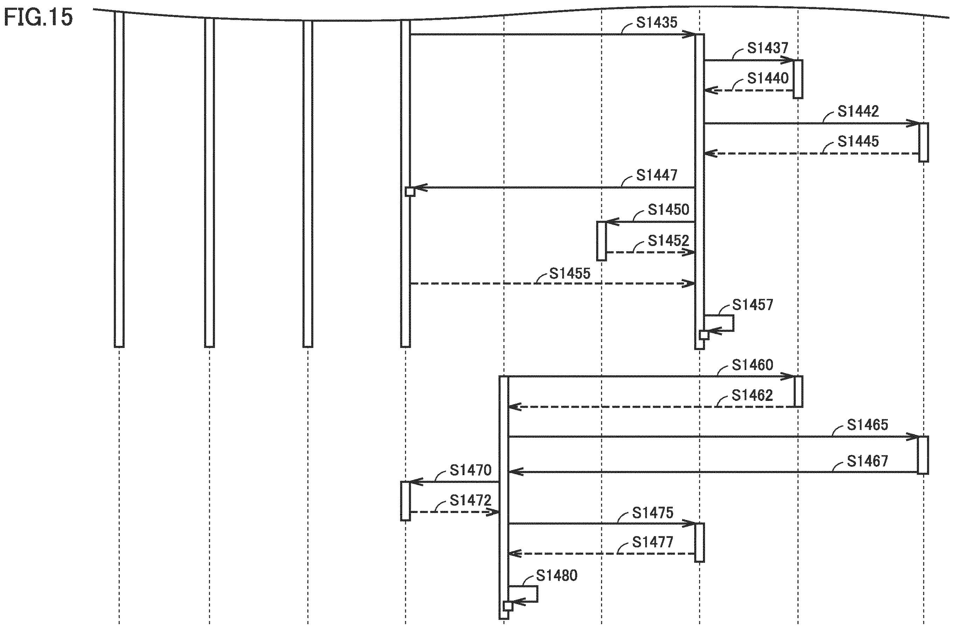

Fig. 14 is a diagram illustrating an example of a first half of a sequence based on the second module configuration. Fig. 15 is a diagram illustrating an example of a second half of the sequence based on the second module configuration. The sequence illustrated in Figs. 14 and 15 is executed by CPU 301. In one aspect, CPU 301 may implement the sequence based on the second module configuration by executing simulation program 100 loaded from secondary storage device 303 into primary storage device 302.

In step S1402, integrated simulation execution unit 1101 receives a simulation start command from the user. In step S1405, integrated simulation execution unit 1101 transmits a request for generation of a virtual time to virtual time generation unit 1102. In step S1407, virtual time generation unit 1102 transmits an activation request to virtual workpiece motion script execution unit 1105. Virtual workpiece motion script execution unit 1105 is activated in response to the activation request.

In step S1410, virtual time generation unit 1102 transmits an activation request to PLC program execution unit 1322. In step S1412, virtual time generation unit 1102 transmits an activation request to robot program execution unit 1332. Robot program execution unit 1332 is activated in response to the activation request. In one aspect, the activation requests in steps S1407 to S1412 may each include the virtual time.

In step S1415, virtual time generation unit 1102 transmits an operation command to PLC program execution unit 1322. PLC program execution unit 1322 executes a predetermined operation in response to the operation command. In step S1417, PLC program execution unit 1322 notifies virtual time generation unit 1102 of an operation result. The operation result may include, for example, a PLC variable.

In step S1420, virtual time generation unit 1102 transmits an operation command to robot program execution unit 1332. PLC program execution unit 1322 executes a predetermined operation in response to the operation command. In step S1422, robot program execution unit 1332 notifies virtual time generation unit 1102 of an operation result. The operation result may include, for example, a robot controller variable.

In step S1425, virtual time generation unit 1102 transmits an operation command to virtual workpiece motion script execution unit 1105. In one aspect, the operation command may include the operation result in step S1417 and the operation result in step S1422. In step S1427, virtual workpiece motion script execution unit 1105 executes a virtual workpiece automatic execution script in response to the operation command. The virtual workpiece automatic execution script includes, for example, a script created on fifth UI 1000. Further, unlike the sequence illustrated in Fig. 12, the virtual workpiece automatic execution script uses the PLC emulation result and the robot controller emulation result.

In step S1430, virtual workpiece motion script execution unit 1105 transmits an operation execution notification to collision filter group setting unit 1112. In one aspect, the operation execution notification may include the current position of an object or the like. In another aspect, the operation execution notification may include information indicating the current scene.

In step S1432, collision filter group setting unit 1112 updates the collision filter group upon receipt of the operation execution notification. For example, collision filter group setting unit 1112 changes a group to which a virtual workpiece belongs on the basis of scene switching. In step S1435, virtual workpiece motion script execution unit 1105 transmits a collision detection request to 3D shape collision detection unit 1116.

In step S1437, 3D shape collision detection unit 1116 transmits a request for acquisition of a command value of each actuator (servomotor or the like) controlled by the PLC to PLC program execution unit 1322. Here, the command value of each actuator controlled by the PLC corresponds to a command value output from the emulated PLC to each actuator. In step S1440, PLC program execution unit 1322 transmits the command value of each actuator controlled by the PLC to 3D shape collision detection unit 1116.

In step S1442, 3D shape collision detection unit 1116 transmits a request for acquisition of a command value of each axis of the robot to robot program execution unit 1332. Here, the command value of each axis of the robot corresponds to a command value output from the emulated robot controller to each motor (each axis) constituting the robot. In step S1445, robot program execution unit 1332 transmits the command value of each axis of the robot to 3D shape collision detection unit 1116 in response to the request for acquisition.

In step S1447, 3D shape collision detection unit 1116 transmits a request for acquisition of the position of the virtual workpiece to virtual workpiece motion script execution unit 1105 in response to the collision detection request.

In step S1450, 3D shape collision detection unit 1116 transmits a request for acquisition of the collision filter group to collision filter group setting unit 1112. In step S1452, collision filter group setting unit 1112 transmits the collision filter group to 3D shape collision detection unit 1116 in response to the request for acquisition.

In step S1455, virtual workpiece motion script execution unit 1105 transmits the position of the virtual work to 3D shape collision detection unit 1116 in response to the request for acquisition (step S1447). In one aspect, the communications in steps S1437 to S1455 may be executed asynchronously and simultaneously.

In step S1457, 3D shape collision detection unit 1116 executes a collision detection process upon receipt of the command value of each actuator controlled by the PLC, the command value of each axis of the robot, the collision filter group, and the position of the virtual workpiece.

In step S1460, 3D shape display unit 1109 transmits a request for acquisition of the command value of each actuator controlled by the PLC to PLC program execution unit 1322. In step S1462, PLC program execution unit 1322 transmits the command value of each actuator controlled by the PLC to 3D shape display unit 1109 in response to the request for acquisition.

In step S1465, 3D shape display unit 1109 transmits a request for acquisition of the command value of each axis of the robot to robot program execution unit 1332. In step S1467, robot program execution unit 1332 transmits the command value of each axis of the robot to 3D shape display unit 1109 in response to the request for acquisition.

In step S1470, 3D shape display unit 1109 transmits a request for acquisition of the position of the virtual workpiece to virtual workpiece motion script execution unit 1105. In step S1472, virtual workpiece motion script execution unit 1105 transmits the position of the virtual work to 3D shape display unit 1109 in response to the request for acquisition.

In step S1475, 3D shape display unit 1109 transmits a request for acquisition of collision state information to 3D shape collision detection unit 1116. In step S1477, 3D shape collision detection unit 1116 transmits the collision state information to 3D shape display unit 1109 in response to the request for acquisition. As an example, the collision state information includes identification information on each object, a collision occurrence time, and the like in a case where a collision occurs between objects. In step S1480, 3D shape collision detection unit 1116 updates the display of the screen. For example, the display of the visualizer 530 is updated each time step S1480 is executed.

### (C-5. Third module configuration)

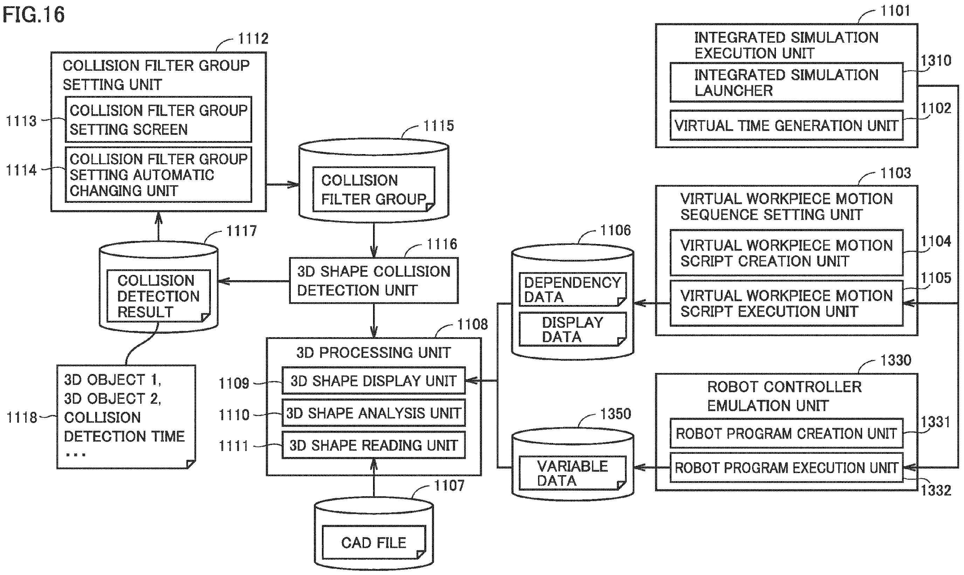

Fig. 16 is a diagram illustrating an example of a third module configuration of simulation program 100. The third module configuration is different from the above-described module configurations in that the third module configuration is provided with, as an emulation function, only the robot controller emulation function.

The third module configuration causes simulation program 100 to emulate only the operation of the robot controller. Simulation program 100 reflects an emulation result of the operation of the robot controller in the simulation.

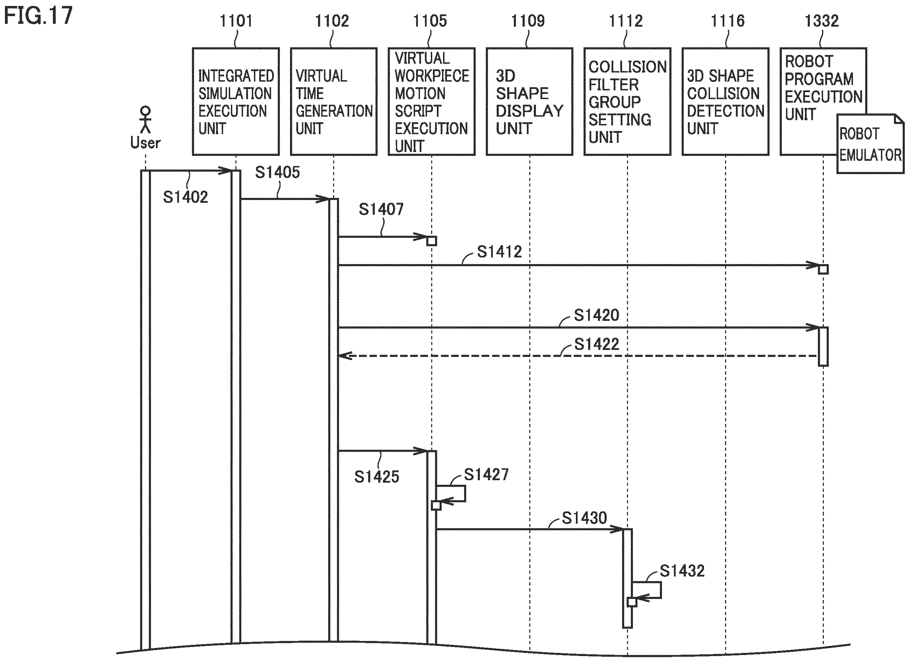

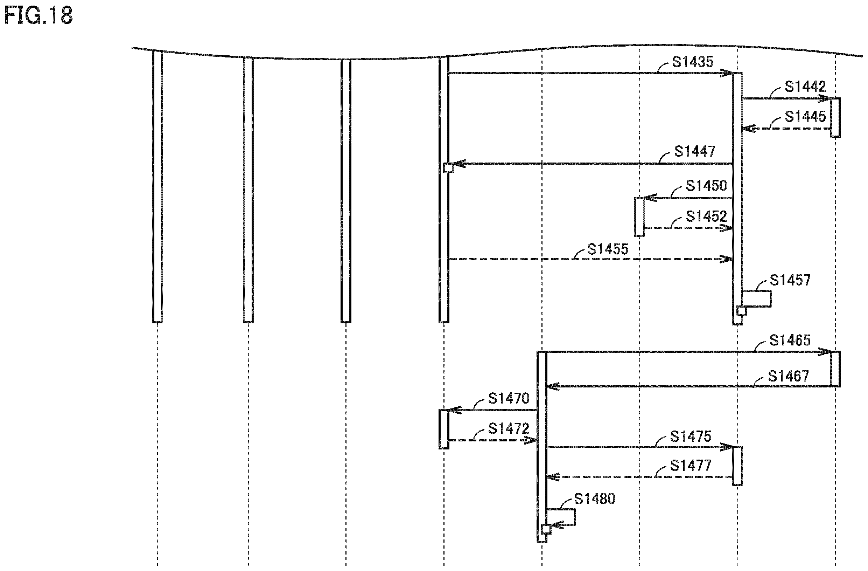

Fig. 17 is a diagram illustrating an example of a first half of a sequence based on the third module configuration. Fig. 18 is a diagram illustrating an example of a second half of the sequence based on the third module configuration. The sequence illustrated in Figs. 17 and 18 is executed by CPU 301. In one aspect, CPU 301 may implement the sequence based on the third module configuration by executing simulation program 100 loaded from secondary storage device 303 into primary storage device 302. The sequence based on the third module configuration is obtained by removing the communication processes on PLC program execution unit 1322 from the sequence based on the second module configuration. Note that all the processes included in the sequence based on the third module configuration is included in the sequence based on the second module configuration. Therefore, no description of such processes will be given below.

### (C-6. Fourth module configuration)

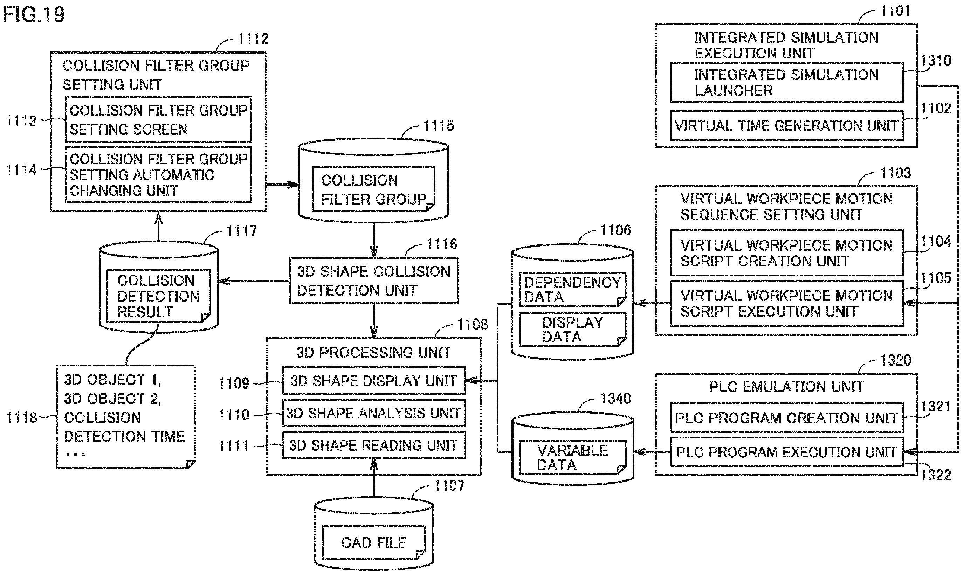

Fig. 19 is a diagram illustrating an example of a fourth module configuration of simulation program 100. The fourth module configuration is different from the above-described module configurations in that fourth module configuration is provided with, as an emulation function, only the PLC emulation function.

The fourth module configuration causes simulation program 100 to emulate only the operation of the PLC. Simulation program 100 reflects an emulation result of the operation of the PLC in the simulation.

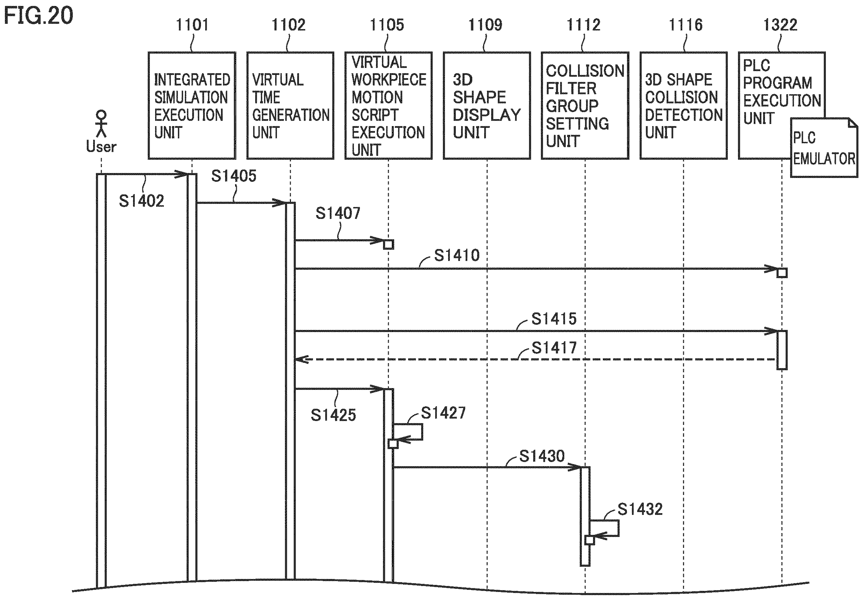

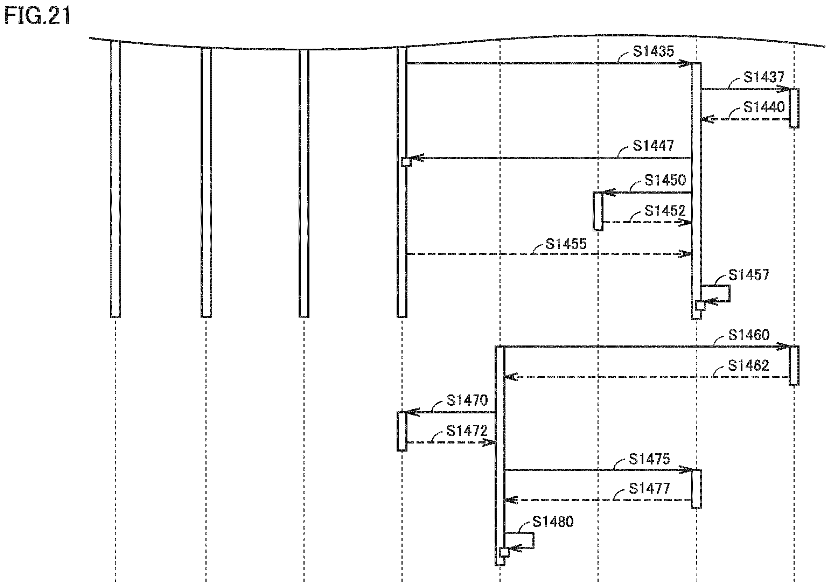

Fig. 20 is a diagram illustrating an example of a first half of a sequence based on the fourth module configuration. Fig. 21 is a diagram illustrating an example of a second half of the sequence based on the fourth module configuration. The sequence illustrated in Figs. 20 and 21 is executed by CPU 301. In one aspect, CPU 301 may implement the sequence based on the fourth module configuration by executing simulation program 100 loaded from secondary storage device 303 into primary storage device 302. The sequence based on the fourth module configuration is obtained by removing the communication processes on robot program execution unit 1332 from the sequence based on the second module configuration. Note that all the processes included in the sequence based on the fourth module configuration is included in the sequence based on the second module configuration. Therefore, no description of such processes will be given below.

### (C-7. Flowchart)

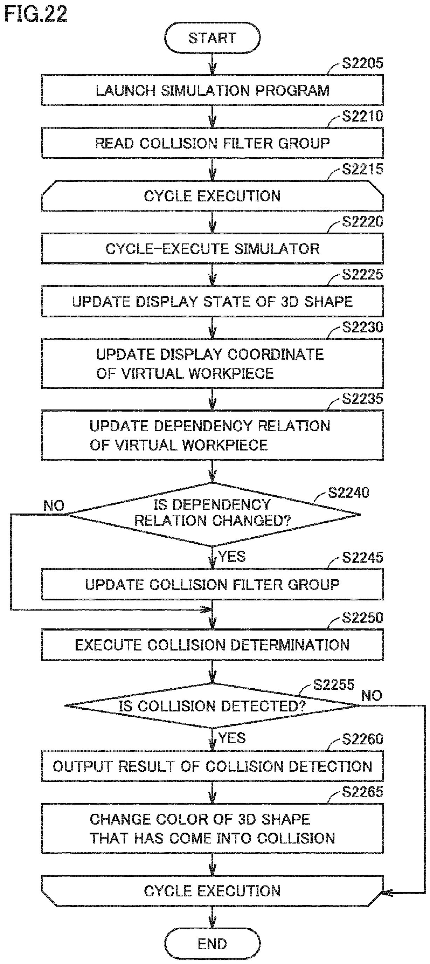

Fig. 22 is an example of a flowchart of simulation program 100. In one aspect, CPU 301 may load a program (simulation program 100) for executing the processes illustrated in Fig. 22 from secondary storage device 303 into primary storage device 302 and execute the program. In another aspect, some or all of the processes may be implemented by a combination of circuit elements configured to execute the processes.

In step S2205, CPU 301 launches simulation program 100. In step S2210, CPU 301 reads a collision filter group. In step S2215, CPU 301 repeats step S2220 and the subsequent steps. In step S2220, CPU 301 starts cycle execution of the simulator. In this step, CPU 301 sequentially executes a virtual workpiece motion script.

In step S2225, CPU 301 updates a display state of a 3D shape. In step S2230, CPU 301 updates display coordinates of a virtual workpiece. In steps S2225 and S2230, the display of visualizer 530 is updated. In step S2235, CPU 301 executes a process of updating a dependency relation of the virtual workpiece. For example, at the time of scene switching, CPU 301 updates the dependency relation of the virtual workpiece and a group to which the virtual workpiece belongs. Further, CPU 301 may change the colors of objects belonging to the same group to the same color with reference to the updated collision filter group.

In step S2240, CPU 301 determines whether the dependency relation of the virtual workpiece has been changed in step S2235. When determining that the dependency relation of the virtual workpiece has been changed in step S2235 (YES in step S2240), CPU 301 transfers the control to step S2245. Otherwise (NO in step S2240), CPU 301 transfers the control to step S2250.

In step S2245, CPU 301 updates the collision filter group. For example, CPU 301 updates the dependency relation of the virtual workpiece and the group to which the virtual workpiece belongs. In step S2250, CPU 301 refers to the updated collision filter group to execute a collision determination on each object.

In step S2255, CPU 301 determines whether a collision between objects has been detected. When determining that a collision between the objects has been detected (YES in step S2255), CPU 301 transfers the control to step S2060. Otherwise (NO in step S2255), CPU 301 transfers the control to the beginning of the cycle execution in step S2015.

In step S2260, CPU 301 outputs the result of the collision detection as a log. The user can know the details of the collision by referring to the log. In step S2265, CPU 301 changes the colors of 3D shapes (objects) that have come into collision with each other. This process changes, for example, the colors of the objects that have come into collision with each other, the objects being displayed on visualizer 530, and thus allows the user to easily notice the occurrence of the collision.

As described above, simulation program 100 and information processing device 300 on which simulation program 100 is installed according to the present embodiment manages objects with the objects grouped to prevent the collision detection process of detecting a collision between objects belonging to the same group from being executed. This allows simulation program 100 and information processing device 300 to reduce computational resources necessary for simulation.

Furthermore, simulation program 100 and information processing device 300 execute the process of updating the dependency relation between objects and grouping the objects each time a scene is switched. This allows simulation program 100 and information processing device 300 to dynamically prevent the execution of an unnecessary collision detection process of detecting a collision between objects for each scene.

### <D. Appendix>

The present embodiment as described above includes the following technical ideas.

### [Configuration 1]

A program (100) for causing at least one processor (301) to execute instructions, the instructions including:
determining a group to which a first object (150) belongs and a group to which a second object (140) belongs;
executing a simulation including the first object and the second object;
executing a collision determination between the first object and the second object during execution of the simulation; and
changing the group to which the first object belongs when a predetermined condition is satisfied, in which
the collision determination is executed only when the group to which the first object belongs is different from the group to which the second object belongs.

### [Configuration 2]

In the program according to configuration 1, the predetermined condition is defined by an object on which the first object depends in the simulation.

### [Configuration 3]

In the program according to configuration 2, the instructions further include changing the object on which the first object depends to the second object based on a change from a state in which the first object is out of contact with the second object to a state in which the first object is in contact with the second object.

### [Configuration 4]

In the program according to configuration 2, the instructions further include:
monitoring a change of an object with which the first object is in contact; and
changing the group to which the first object belongs based on the object with which the first object is in contact each time the change of the object with which the first object is in contact is detected.

### [Configuration 5]

In the program according to any one of configurations 1 to 4, the instructions further include displaying, on a display, an execution status of the simulation,
a color of the first object is the same as a color to the second object when the first object and the second object belong to an identical group, and
the color of the first object is different from the color of the second object when the first object and the second object belong to different groups.

### [Configuration 6]

In the program according to any one of configurations 1 to 5, the instructions further include changing the color of the first object or a color of an object with which the first object is in contact based on detection of a collision of the first object.

### [Configuration 7]

In the program according to any one of configurations 1 to 6, the instructions further include:
generating a filter configured to make an object belonging to the group to which the first object belongs not subject to a determination of a collision with the first object; and
making, in the collision determination, an object included in the filter not subject to the determination of a collision with the first object.

### [Configuration 8]

In the program according to any one of configurations 1 to 7, the instructions further include:
setting a dependency relation between the first object and the second object; and
setting the first object and the second object to belong to an identical group based on the dependency relation set between the first object and the second object.

### [Configuration 9]

In the program according to configuration 8, the instructions further include:
providing a template for defining the predetermined condition; and
receiving, for each template, input to add a process for the first object.

### [Configuration 10]

In the program according to configuration 9, the process for the first object includes a process of changing an object on which the first object depends.

### [Configuration 11]

In the program according to configuration 9 or 10, the process for the first object includes a process of switching between on and off of visualization of the first object or the second object.

### [Configuration 12]

In the program according to any one of configurations 9 to 11, the instructions further include:
storing a plurality of scripts created based on the template; and
receiving input to determine an execution sequence of each of the plurality of scripts.

### [Configuration 13]

In the program according to any one of configurations 1 to 12, the instructions further include switching between a case where motion of one or more objects included in the simulation is performed by simulation and a case where the motion is performed by operating an emulator.

### [Configuration 14]

In the program according to any one of configurations 1 to 13, the instructions further include outputting log information including information on the first object, information on the second object, and a collision time based on detection of a collision between the first object and the second object.

### [Configuration 15]

A device including:
a memory (303) storing a program according to any one of configurations 1 to 14; and
a processor (301) configured to execute the program.

It should be understood that the embodiment disclosed herein is illustrative in all respects and not restrictive. The scope of the present disclosure is defined by the claims rather than the above description, and the present disclosure is intended to include the claims, equivalents of the claims, and all modifications within the scope. Further, the disclosed contents described in the embodiment and each modification are intended to be practiced separately or in combination within an allowable scope.

### REFERENCE SIGNS LIST

20: line, 100: simulation program, 110, 120, 130: scene, 140: robot arm, 150: workpiece, 160: base, 170: tray, 200: integrated controller, 201: IPC device, 202: control panel, 203: management device, 204: transfer robot, 205: sensor, 206: LiDAR 207: cloud environment, 208: database, 209: simulator, 220: upper transmission path, 230: lower transmission path, 240: field device, 300: information processing device, 301: CPU, 302: primary storage device, 303: secondary storage device, 304: external device interface, 305: input interface, 306: output interface, 307: communication interface, 410: virtual PLC, 411: PLC body, 412: servomotor, 420: virtual robot, 421: robot controller, 422: robot body, 430: EtherCat shared memory, 431: input data, 432: output data, 500: IDE, 510: ladder software, 520: robot program software, 530: visualizer, 610: editor, 620: tool box, 630: template, 640: condition, 710: script list, 720: script execution setting, 1101: integrated simulation execution unit, 1102: virtual time generation unit, 1103: virtual workpiece motion sequence setting unit, 1104: virtual workpiece motion script creation unit, 1105: virtual workpiece motion script execution unit, 1106: simulation setting, 1107: CAD database, 1108: 3D processing unit, 1109: 3D shape display unit, 1110: 3D shape analysis unit, 1111: 3D shape reading unit, 1112: collision filter group setting unit, 1113: collision filter group setting screen, 1114: collision filter group setting automatic changing unit, 1115: collision filter group database, 1116: 3D shape collision detection unit, 1117: collision detection result database, 1118: collision detection result, 1140: virtual workpiece motion script, 1320: PLC emulation unit, 1321: PLC program creation unit, 1322: PLC program execution unit, 1330: robot controller emulation unit, 1331: robot program creation unit, 1332: robot program execution unit, 1340: PLC variable database, 1350: robot controller variable database

## Claims

1. A program for causing at least one processor to execute instructions, the instructions comprising:
determining a group to which a first object belongs and a group to which a second object belongs;
executing a simulation including the first object and the second object;
executing a collision determination between the first object and the second object during execution of the simulation; and
changing the group to which the first object belongs when a predetermined condition is satisfied,
wherein the collision determination is executed only when the group to which the first object belongs is different from the group to which the second object belongs.

2. The program according to claim 1, wherein
the predetermined condition is defined by an object on which the first object depends in the simulation.

3. The program according to claim 2, wherein
the instructions further comprise changing the object on which the first object depends to the second object based on a change from a state in which the first object is out of contact with the second object to a state in which the first object is in contact with the second object.

4. The program according to claim 2, wherein
the instructions further comprise:
monitoring a change of an object with which the first object is in contact; and
changing the group to which the first object belongs based on the object with which the first object is in contact each time the change of the object with which the first object is in contact is detected.

5. The program according to any one of claims 1 to 4, wherein
the instructions further comprise displaying, on a display, an execution status of the simulation,
a color of the first object is the same as a color of the second object when the first object and the second object belong to an identical group, and
the color of the first object is different from the color of the second object when the first object and the second object belong to different groups.

6. The program according to any one of claims 1 to 5, wherein
the instructions further comprise changing the color of the first object or a color of an object with which the first object is in contact based on detection of a collision of the first obj ect.

7. The program according to any one of claims 1 to 6, wherein
the instructions further comprise:
generating a filter configured to make an object belonging to the group to which the first object belongs not subject to a determination of a collision with the first object; and
making, in the collision determination, an object included in the filter not subject to the determination of a collision with the first object.

8. The program according to any one of claims 1 to 7, wherein
the instructions further comprise:
setting a dependency relation between the first object and the second object; and
setting the first object and the second object to belong to an identical group based on the dependency relation set between the first object and the second object.

9. The program according to claim 8, wherein
the instructions further comprise:
providing a template for defining the predetermined condition; and
receiving, for each template, input to add a process for the first object.

10. The program according to claim 9, wherein
the process for the first object includes a process of changing an object on which the first object depends.

11. The program according to claim 9 or 10, wherein
the process for the first object includes a process of switching between on and off of visualization of the first object or the second object.

12. The program according to any one of claims 9 to 11, wherein
the instructions further comprise:
storing a plurality of scripts created based on the template; and
receiving input to determine an execution sequence of each of the plurality of scripts.

13. The program according to any one of claims 1 to 12, wherein
the instructions further comprise switching between a case where motion of one or more objects included in the simulation is performed by simulation and a case where the motion is performed by operating an emulator.

14. The program according to any one of claims 1 to 13, wherein
the instructions further comprise outputting log information including information on the first object, information on the second object, and a collision time based on detection of a collision between the first object and the second object.

15. A device comprising:
a memory storing a program according to any one of claims 1 to 14; and
a processor configured to execute the program.
